# EUROPEAN PATENT APPLICATION

(11) **EP 4 727 280 A1**
(43) Date of publication of application: **15.04.2026**
(21) Application number: 25206233.6
(22) Date of filing: 02.10.2025
(51) Int. Cl.: H10B 12/00

(54) **SEMICONDUCTOR DEVICE**

(30) Priority: 08.10.2024 KR 20240136822
(71) Applicant: Samsung Electronics Co., Ltd., Suwon-si, Gyeonggi-do 16677 (KR)
(72) Inventor: KIM, Seokwon, 16677 Suwon-si, Gyeonggi-do (KR); LEE, Jungha, 16677 Suwon-si, Gyeonggi-do (KR); PARK, Sanghyun, 16677 Suwon-si, Gyeonggi-do (KR); LEE, Dosun, 16677 Suwon-si, Gyeonggi-do (KR); LEE, Sunjung, 16677 Suwon-si, Gyeonggi-do (KR); LEE, Jongwon, 16677 Suwon-si, Gyeonggi-do (KR)
(74) Representative: Kuhnen & Wacker Patent- und Rechtsanwaltsbüro PartG mbB

(57) **Abstract**

A semiconductor device (10) including a bit line (BL) extending in a vertical direction (D3) on a substrate, a transistor body (TRB) electrically connected to the bit line (BL) and including a first source/drain region (SD1), a channel region (CH), and a second source/drain region (SD2) in a first horizontal direction (D1), a gate electrode extending in a second horizontal direction (D2) intersecting the first horizontal direction (D1) and on the channel region (CH) where a gate dielectric layer is between the gate electrode and the channel region (CH), and a cell capacitor (CAP) electrically connected to the second source/drain region (SD2) and including a storage electrode (SE), a capacitor dielectric layer (CIL) and a plate electrode (PE) in the first horizontal direction (D1). A doped polysilicon layer (DP) and a contact metal layer (BC) are both between the second source/drain region (SD2) and the storage electrode.

## Description

### BACKGROUND

The inventive concept relates to a semiconductor device, and more particularly, to a vertical semiconductor device having a three-dimensional structure.

In order to satisfy high performance and economic feasibility, there is a need to increase the degree of integration of memory devices. In particular, the degree of integration of memory devices is an important factor in determining economic feasibility of a product. Because the degree of integration of a two-dimensional memory device is mainly determined by an area occupied by a unit memory cell, the degree of integration of a two-dimensional memory device is greatly influenced by a level of micro-pattern formation technology. However, because expensive equipment is required to form micro-patterns and an area of a chip die is limited, the degree of integration of the two-dimensional semiconductor device is increasing, but still limited. Accordingly, a vertical semiconductor device having a three-dimensional structure may be needed.

### SUMMARY

The inventive concept relates to a vertical semiconductor device having a three-dimensional structure capable of providing stable performance and improved reliability.

The problems to be solved by the technical idea of the inventive concept are not limited to the above-mentioned problems, and other problems not mentioned will be clearly understood by those skilled in the art from the following description.

According to an aspect of the inventive concept, there is provided a semiconductor device including a bit line extending in a vertical direction on a substrate, a transistor body electrically connected to the bit line and including a first source/drain region, a channel region, and a second source/drain region in a first horizontal direction, a gate electrode extending in a second horizontal direction intersecting the first horizontal direction and on the channel region, where a gate dielectric layer is between the gate electrode and the channel region, and a cell capacitor electrically connected to the second source/drain region and including a storage electrode, a capacitor dielectric layer and a plate electrode in the first horizontal direction, where a doped polysilicon layer and a contact metal layer are both between the second source/drain region and the storage electrode.

According to another aspect of the inventive concept, there is provided a semiconductor device including a plurality of transistor bodies spaced apart from one another in a vertical direction on a substrate and extending in parallel in a first horizontal direction, where ones of the plurality of transistor bodies include a first source/drain region, a channel region, and a second source/drain region, a plurality of gate electrodes spaced apart from one another in the vertical direction, extending in parallel to one another in a second horizontal direction intersecting the first horizontal direction, where ones of the plurality of gate electrodes are on at least a top surface and a bottom surface of the channel region of a respective one of the plurality of transistor bodies, and where a gate dielectric layer is between the channel region and the ones of the plurality of gate electrodes, a plurality of bit lines spaced apart from one another in the second horizontal direction on the substrate, and extending in parallel in the vertical direction, where respective ones of the plurality of bit lines are electrically connected to the first source/drain region of respective ones of the plurality of transistor bodies, and a cell capacitor including a plurality of storage electrodes, a capacitor dielectric layer, and a plate electrode, and electrically connected to the second source/drain region of respective ones of the plurality of transistor bodies, where respective ones of a plurality of doped polysilicon layers are between the second source/drain region of respective ones of the plurality of transistor bodies and respective ones of the plurality of storage electrodes.

According to another aspect of the inventive concept, there is provided a semiconductor device including a bit line extending in a vertical direction on a substrate, a transistor body electrically connected to the bit line and including a first source/drain region, a channel region, and a second source/drain region in a first horizontal direction, a gate electrode extending in a second horizontal direction intersecting the first horizontal direction and on the channel region, wherein a gate dielectric layer is between the gate electrode and the channel region, a cell capacitor electrically connected to the second source/drain region and including a storage electrode, a capacitor dielectric layer, and a plate electrode in the first horizontal direction, and a doped polysilicon layer and a contact metal layer are both between the second source/drain region and the storage electrode, where the second source/drain region has a contact surface with the doped polysilicon layer and has a doping concentration that varies along the first horizontal direction.

### BRIEF DESCRIPTION OF THE DRAWINGS

Embodiments will be more clearly understood from the following detailed description taken in conjunction with the accompanying drawings in which:
FIG. 1 is an equivalent circuit diagram illustrating a cell array of a semiconductor device according to some embodiments;
FIG. 2 is a perspective view illustrating some components of a semiconductor device according to some embodiments;
FIGS. 3A, 3B, 4A, 4B, 5A, 5B, 6A, 6B, 7A, 7B, 8A, 8B, 9A, 9B, 10A, 10B, 11A, 11B, 12A, 12B, 13A, 13B, 14, 15, 16, 17, and 18 are views illustrating a method of manufacturing a semiconductor device according to some embodiments of a process order;
FIGS. 19A, 19B, and 19C are enlarged cross-sectional views illustrating part of a semiconductor device according to some embodiments; and
FIG. 20 is a block diagram illustrating a system including a semiconductor device according to some embodiments.

### DETAILED DESCRIPTION OF THE EMBODIMENTS

Hereinafter, embodiments of the inventive concept will be described in detail with reference to the accompanying drawings.

The term "first," "second," or the like used herein may modify various elements regardless of the order and/or priority thereof, and is used only for distinguishing one element from another element, without limiting example embodiments. The terms "comprises," "comprising," "includes" and/or "including," when used herein, specify the presence of stated elements, but do not preclude the presence of additional elements. The term "and/or" includes any and all combinations of one or more of the associated listed items. The term "connected" as used herein, refers to electrical and/or physical connection between elements or components and does not preclude the presence of additional elements or components therebetween. The term "cover," "covering" or the like used herein may specify an element, component or layer that is partially or fully, on, surrounding, overlapping or encasing another element, component, or layer.

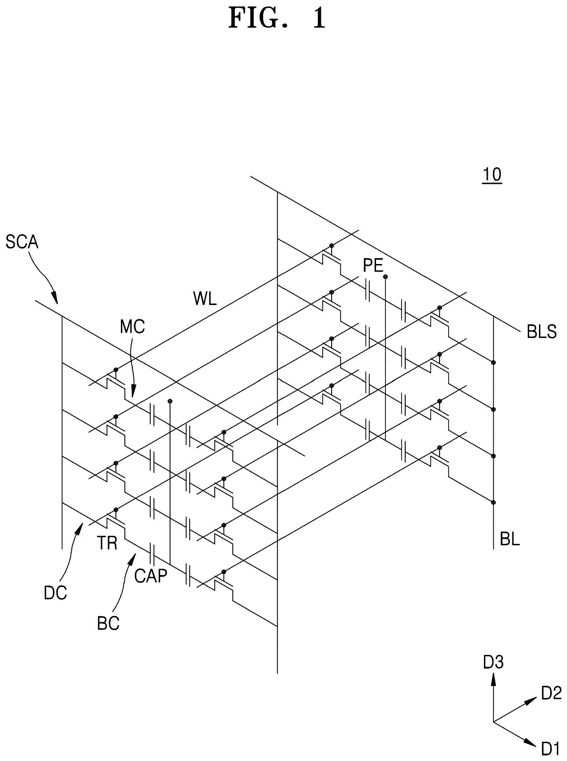

FIG. 1 is an circuit diagram illustrating a cell array of a semiconductor device 10 according to some embodiments.

Referring to FIG. 1, the semiconductor device 10 according to the inventive concept may include a plurality of memory cells MC including cell transistors TR and cell capacitors CAP arranged in a vertical direction D3 and connected to each other.

The plurality of memory cells MC may be apart from one another in the first horizontal direction D1 and the vertical direction D3, respectively, and may form a row to form a sub-cell array SCA. In addition, in the semiconductor device 10, the plurality of sub-cell arrays SCA may be apart from one another in a second horizontal direction D2 intersecting the first horizontal direction D1.

A plurality of word lines WL may extend in the second horizontal direction D2 and may be apart from one another in the first horizontal direction D1 and the vertical direction D3. A plurality of bit lines BL may extend in the vertical direction D3 and may be apart from one another in the first horizontal direction D1 and the second horizontal direction D2.

In some embodiments, some of the plurality of bit lines BL may be connected to one another by a bit line strapping line BLS extending in the first horizontal direction D1. For example, the bit line strapping line BLS may connect bit lines BL arranged in the first horizontal direction D1 among the plurality of bit lines BL.

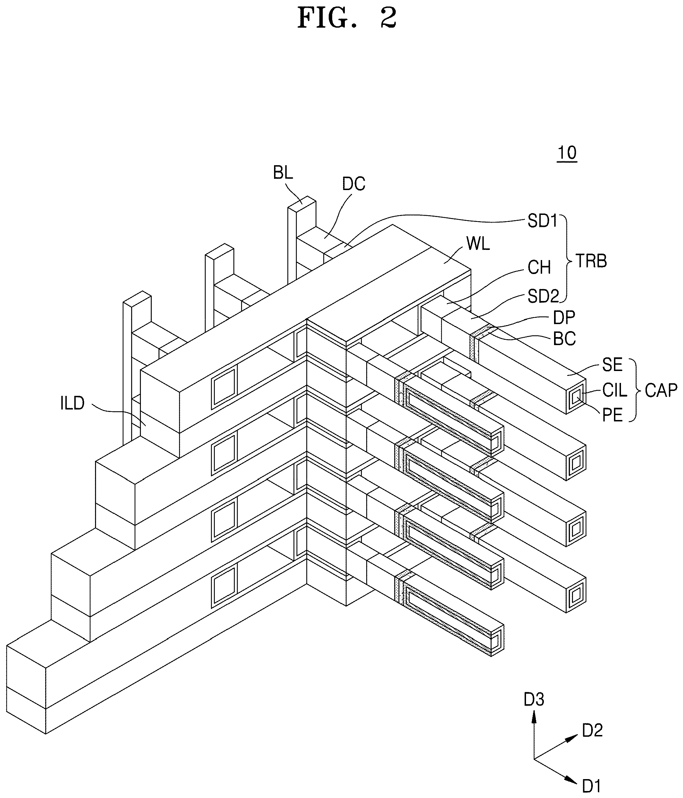

The plurality of cell capacitors CAP may be commonly connected (i.e. connected through a common node) to a plate electrode PE extending in the second horizontal direction D2 and the vertical direction D3. Although the plate electrode PE is illustrated as extending (i.e. spaced apart) in the vertical direction D3 in FIG. 2, the plate electrode PE arranged in the second horizontal direction D2 may be integrated (i.e. the plate electrodes PE arranged in the second horizontal direction D2 may function as a single entity and/or may be electrically connected though a common node). In other words, the plurality of cell capacitors CAP may be electrically connected to the plurality of bit lines BL which may be spaced apart in the second horizontal direction D2 and extend in the vertical direction D3. The plate electrode PE may be spaced apart in the vertical direction D3 and the second horizontal direction D2 and may extend in the first horizontal direction D1.

The cell capacitor CAP and the cell transistor TR arranged in the first horizontal direction D1 may be arranged in mirror image symmetry with respect to a surface extending in the second horizontal direction D2 and the vertical direction D3 on which the plate electrode PE is arranged.

The cell transistor TR may be connected to the bit line BL through a direct contact DC and may be connected to the cell capacitor CAP through a buried contact BC. The buried contact BC may be a contact metal layer 220 and may be adjacent to a doped polysilicon layer DP (i.e. 210) and a second source/drain region SD2 (i.e. 124).

FIG. 2 is a perspective view illustrating some components of a semiconductor device according to some embodiments.

Referring to FIG. 2, the semiconductor device 10 according to the inventive concept may include transistor bodies TRB and cell capacitors CAP stacked in the vertical direction D3 and connected to each other.

Word lines WL and interlayer insulating patterns ILD may be alternately stacked in the vertical direction D3 orthogonal to the first horizontal direction D1 and the second horizontal direction D2. Each of the word lines WL may include a line portion extending in the first horizontal direction D1 and a gate electrode protruding (i.e. extending) from the line portion in the second horizontal direction D2. In a plan view, a pair of word lines WL may be mirror images of each other with respect to the plate electrode PE.

The transistor bodies TRB constitutes, makes up, or forms the transistor TR (refer to FIG. 1) may be stacked in the vertical direction D3 and may be apart from one another in the first horizontal direction D1 and the second horizontal direction D2. That is, the transistor bodies TRB may be three-dimensionally arranged. The transistor body TRB may include Si or Ge. For example, the transistor body TRB may include single crystal silicon.

The transistor body TRB may have a bar shape having a long axis in the second horizontal direction D2. The transistor body TRB may include first and second source/drain regions SD1 and SD2 apart from each other, and a channel region CH between the first and second source/drain regions SD1 and SD2. The transistor body TRB may be doped with a dopant in the first and second source/drain regions SD1 and SD2.

The transistor body TRB may pass through the word line WL in the second horizontal direction D2. In some embodiments, the word line WL may have a gate all-around structure surrounding the channel region CH of the transistor body TRB.

The bit line BL may extend in the vertical direction D3 across the word line WL. The bit lines BL may be apart from one another in the first horizontal direction D1 and the second horizontal direction D2. The bit line BL may be connected to the first source/drain region SD1 of the transistor body TRB through the direct contact DC. The direct contact DC may be omitted, and the bit line BL may be directly bonded to the first source/drain region SD1 of the transistor body TRB.

The cell capacitor CAP may include a storage electrode SE, a capacitor dielectric layer CIL, and the plate electrode PE. The capacitor dielectric layer CIL may conformally cover or be on an internal wall of the storage electrode SE. In addition, the plate electrode PE may fill the capacitor dielectric layer CIL.

The cell capacitor CAP may be connected to the second source/drain region SD2 of the transistor body TRB. In the semiconductor device 10 according to the inventive concept, the cell capacitor CAP may be connected to the second source/drain region SD2 of the transistor body TRB through a doped polysilicon layer DP and the buried contact BC.

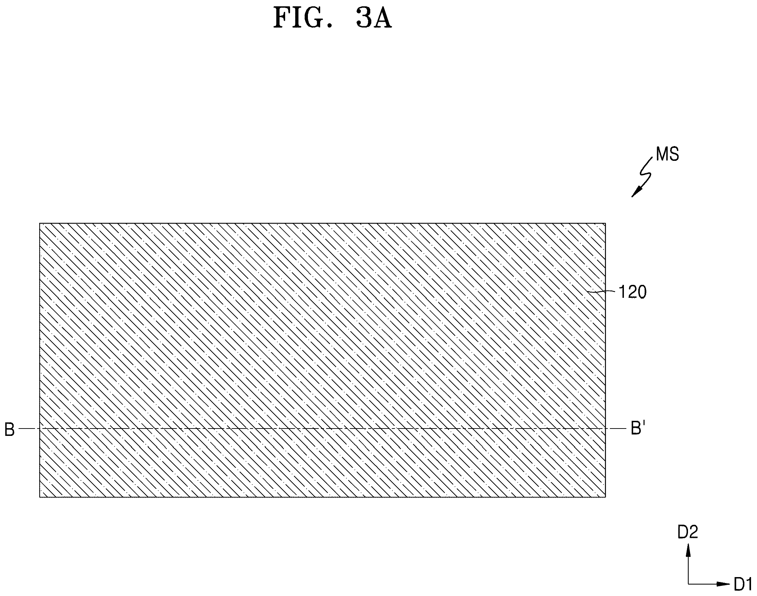

FIGS. 3A, 3B, 4A, 4B, 5A, 5B, 6A, 6B, 7A, 7B, 8A, 8B, 9A, 9B, 10A, 10B, 11A, 11B, 12A, 12B, 13A, 13B, 14, 15, 16, 17, and 18 are views illustrating a method of manufacturing a semiconductor device according to some embodiments of a process order.

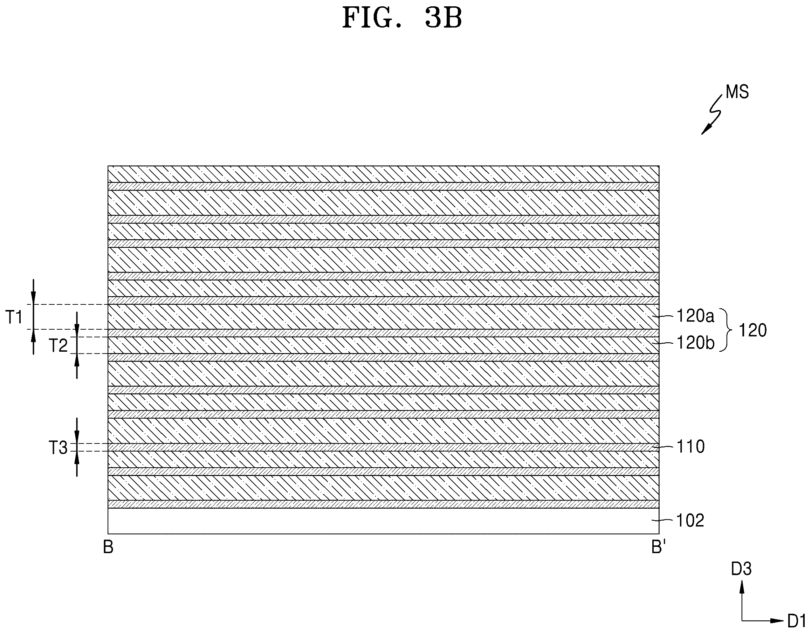

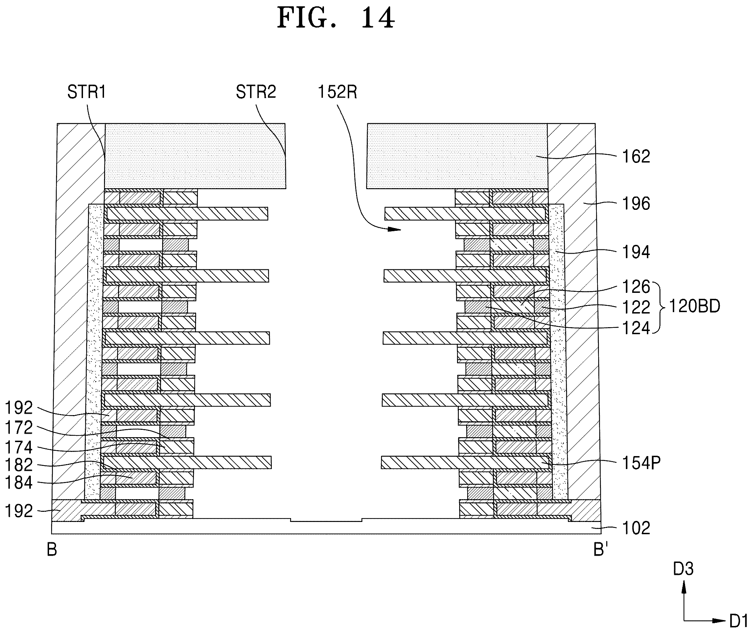

Specifically, FIGS.3A, 4A, 5A, 6A, 7A, 8A, 9A, 10A, 11A, 12A, and 13A are plan views viewed from the top. FIGS. 3B, 4B, 5B, 6B, 7B, 8B, 9B, 10B, 11B, 12B, and 13B are cross-sectional views taken along line B-B' of FIGS. 3A, 4A, 5A, 6A, 7A, 8A, 9A, 10A, 11A, 12A, and 13A. In addition, FIGS. 14, 15, 16, 17, and18 are cross-sectional views corresponding to line B-B' of the previous drawings.

Referring to FIGS. 3A and 3B, a stacked structure MS, in which a plurality of sacrificial layers 110 and a plurality of semiconductor layers 120 are alternately stacked, is formed on a substrate 102.

The substrate 102 may include a semiconductor material. For example, the substrate 102 may include a semiconductor material such as silicon (Si) or germanium (Ge). Alternatively, the substrate 102 may include a silicon-on-insulator (SOI) or a germanium-on-insulator (GeOI).

Each of the plurality of sacrificial layers 110 and the plurality of semiconductor layers 120 may include a single crystal semiconductor material. The sacrificial layer 110 may include a semiconductor material having etch selectivity with respect to the semiconductor layer 120. In some embodiments, the sacrificial layer 110 may have etch selectivity with respect to the substrate 102. In addition, the semiconductor layer 120 may include a material having the same or similar etching characteristics as the substrate 102, or may include the same material as the substrate 102.

In some embodiments, each of the plurality of sacrificial layers 110 may include silicon germanium (SiGe), and each of the plurality of semiconductor layers 120 may include Si. In other embodiments, each of the plurality of semiconductor layers 120 may include a single crystal 2D material semiconductor or a single crystal oxide semiconductor material.

The plurality of sacrificial layers 110 and the plurality of semiconductor layers 120 may be formed by a chemical vapor deposition (CVD) process or an atomic layer deposition (ALD) process. In some embodiments, each of the plurality of sacrificial layers 110 and the plurality of semiconductor layers 120 may be formed in a single crystal state by using a lower layer as a seed layer, or may be formed in a single crystal state through a heat treatment process.

In some embodiments, each of the plurality of semiconductor layers 120 may include a first semiconductor layer 120a and a second semiconductor layer 120b having different thicknesses. The first semiconductor layer 120a and the second semiconductor layer 120b may be alternately arranged in the vertical direction D3. That is, the first semiconductor layer 120a and the second semiconductor layer 120b may be alternately arranged on each of the plurality of sacrificial layers 110.

Each of the plurality of sacrificial layers 110 and the plurality of semiconductor layers 120 may have a thickness of several tens of nanometers (nm). For example, the first semiconductor layer 120a may have a first thickness T1, the second semiconductor layer 120b may have a second thickness T2, and the sacrificial layer 110 may have a third thickness T3. In some embodiments, the first thickness T1 may be greater than the second thickness T2. The third thickness T3 may be less than each of the first thickness T1 and the second thickness T2. In other embodiments, the plurality of semiconductor layers 120 may have substantially the same thickness.

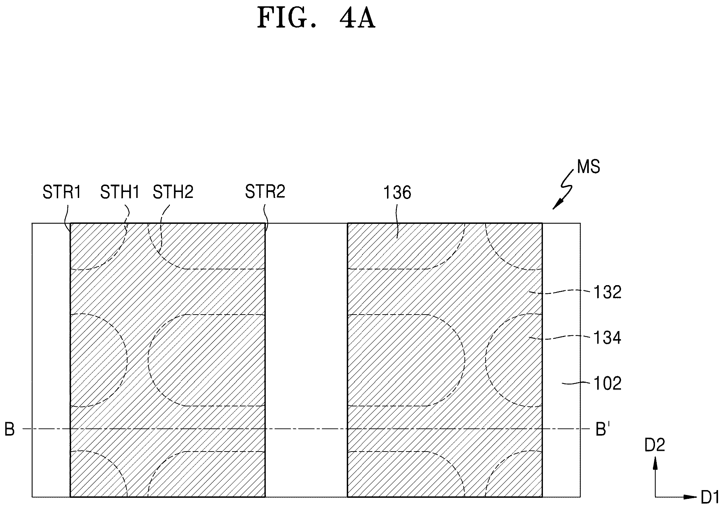

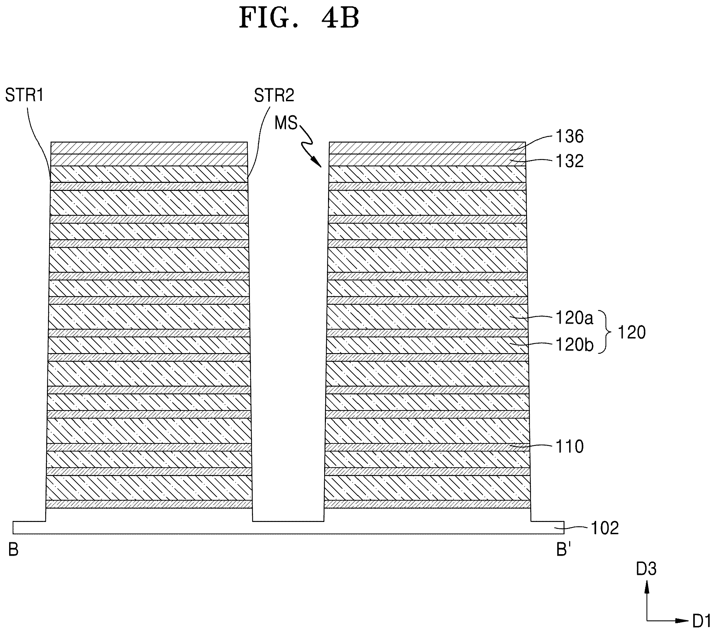

Referring to FIGS. 4A and 4B, after a first mask layer 132 is formed on the stacked structure MS, a plurality of first stacked through holes STH1 and a plurality of second stacked through holes STH2 are formed to expose the substrate 102 through the stacked structure MS by using the first mask layer 132 as an etching mask.

The plurality of first stacked through holes STH1 and the plurality of second stacked through holes STH2 may be apart from each other in the first horizontal direction D1. The plurality of first stacked through holes STH1 may be arranged in a row to be apart from one another in the second horizontal direction D2 orthogonal to the first horizontal direction D1, and the plurality of second stacked through holes STH2 may be arranged in a row to be apart from one another in the first horizontal direction D1.

Next, a first buried insulating layer 134 is formed to fill the plurality of first stacked through holes STH1 and the plurality of second stacked through holes STH2. In some embodiments, the first buried insulating layer 134 may include any one of silicon oxide, silicon oxynitride, carbon-containing silicon oxide, carbon-containing silicon nitride, and/or carbon-containing silicon oxynitride.

Next, after a second mask layer 136 is formed to cover or overlap the stacked structure MS and the first buried insulating layer 134, a first recess STR1 and a second recess STR2 are formed to expose the substrate 102 through the stacked structure MS and the first buried insulating layer 134 by using the second mask layer 136 as an etching mask.

Each of the first recess STR1 and the second recess STR2 may have a shape extending in the second horizontal direction D2. In some embodiments, each of the first recess STR1 and the second recess STR2 may have a tapered shape of which horizontal width is reduced toward the substrate 102.

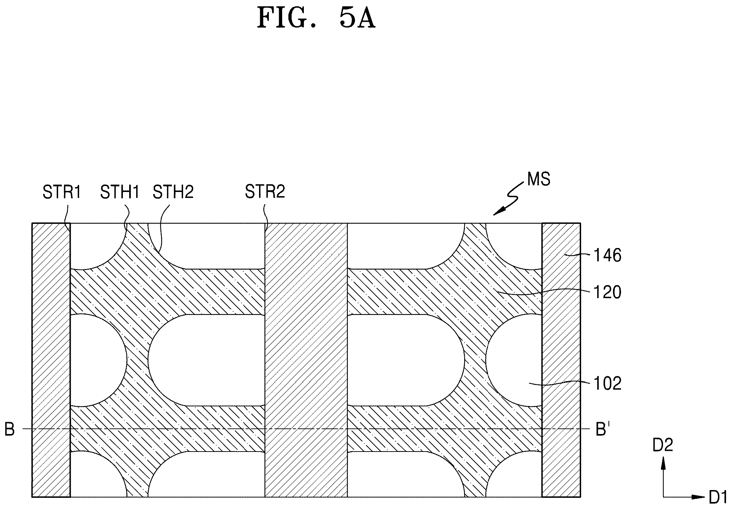

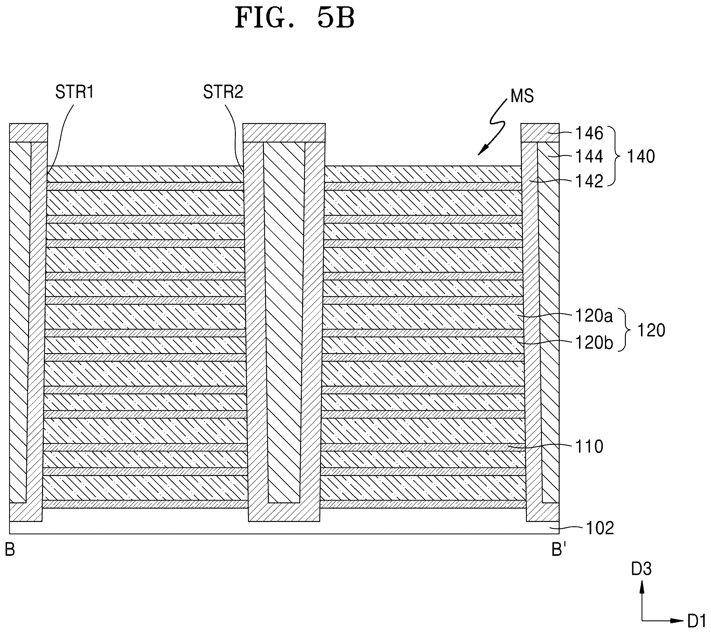

Referring to FIGS. 5A and 5B, after a buried structure 140 is formed to fill the first recess STR1, the second mask layer 136 is removed, and the first buried insulating layer 134 is removed.

The buried structure 140 may include a liner layer 142, a buried layer 144, and a capping layer 146. The liner layer 142 may conformally cover or overlap bottom and side surfaces of the first recess STR1. The buried layer 144 may cover or overlap the liner layer 142 and fill the first recess STR1. The capping layer 146 may cover a top surface of the liner layer 142 and a top surface of the buried layer 144. In some embodiments, each of the liner layer 142 and the capping layer 146 may include silicon nitride. The buried layer 144 may include any one of silicon oxide, silicon oxynitride, carbon-containing silicon oxide, carbon-containing silicon nitride, and/or carbon-containing silicon oxynitride.

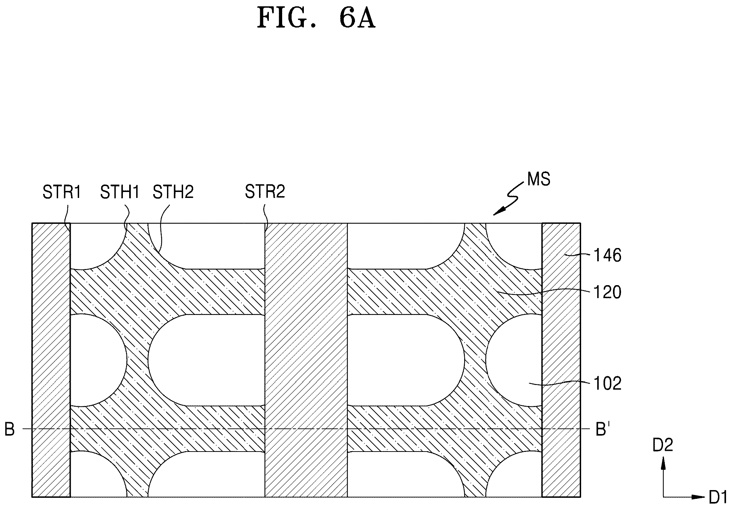

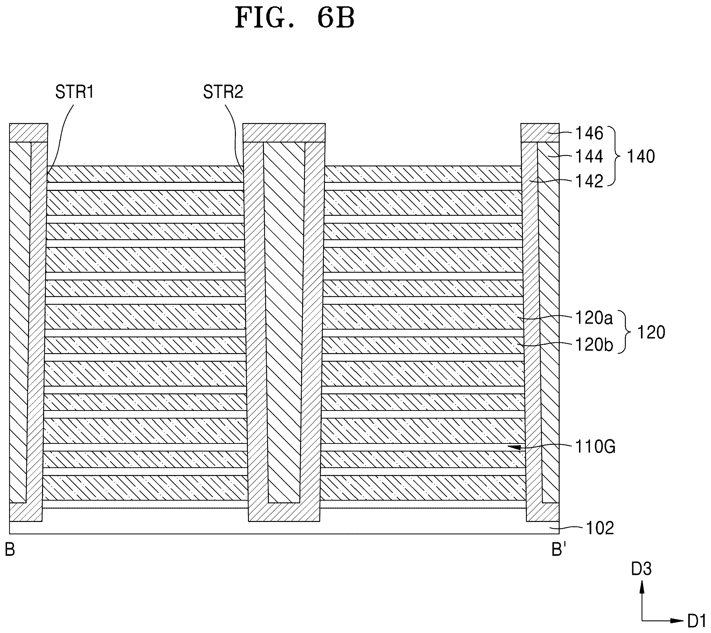

Referring to FIGS. 6A and 6B, the plurality of sacrificial layers 110 are removed through the plurality of first stacked through holes STH1 and the plurality of second stacked through holes STH2 to form a plurality of air gaps 110G among the plurality of semiconductor layers 120.

The plurality of air gaps 110G may be formed by removing the plurality of sacrificial layers 110 by an isotropic etching process having etch selectivity with respect to the substrate 102, the plurality of semiconductor layers 120, the liner layer 142, and the capping layer 146.

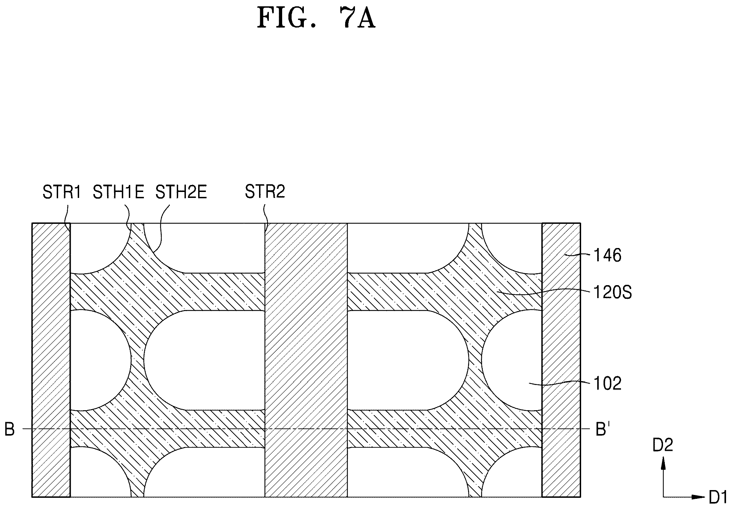

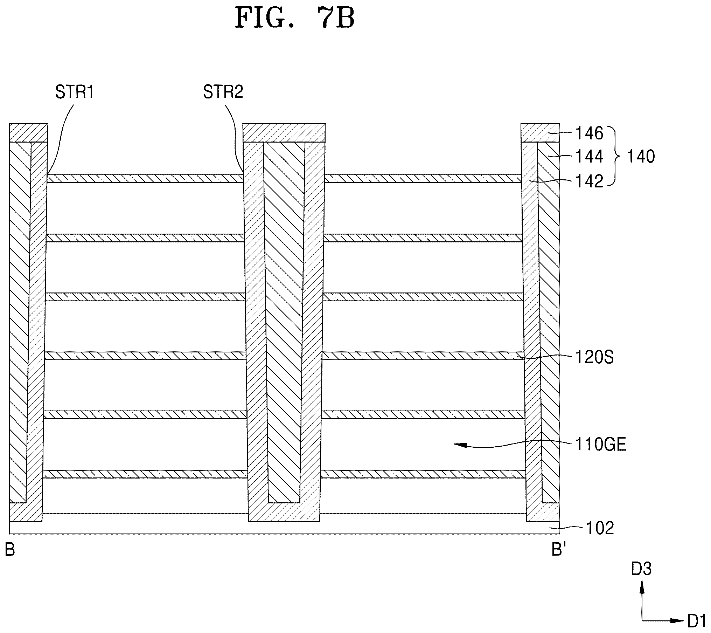

Referring to FIGS. 7A and 7B, a plurality of single crystal slits 120S are formed by removing parts of the plurality of semiconductor layers 120 exposed through the plurality of first stacked through holes STH1, the plurality of second stacked through holes STH2, and the plurality of air gaps 110G.

The plurality of single crystal slits 120S may be formed by removing parts of the plurality of semiconductor layers 120 through an isotropic etching process having etch selectivity with respect to the liner layer 142 and the capping layer 146. In some embodiments, in the process of forming the plurality of single crystal slits 120S, part of the substrate 102 exposed to bottom surfaces of the plurality of first stacked through holes STH1 and the plurality of second stacked through holes STH2 may also be removed.

In some embodiments, when the plurality of semiconductor layers 120 include the plurality of first semiconductor layers 120a and the plurality of second semiconductor layers 120b having different thicknesses, the plurality of second semiconductor layers 120b that have a small thickness may be removed, and only parts of the plurality of first semiconductor layers 120a may remain as the plurality of single crystal slits 120S.

Because parts of the plurality of semiconductor layers 120 are removed, the plurality of first stacked through holes STH1 and the plurality of second stacked through holes STH2 may become a plurality of first stacked through holes STH1E and a plurality of second stacked through holes STH2E extending in a horizontal direction. In addition, because parts of the plurality of semiconductor layers 120 are removed, the plurality of air gaps 110G may become a plurality of extended air gaps 110GE extending in the vertical direction D3.

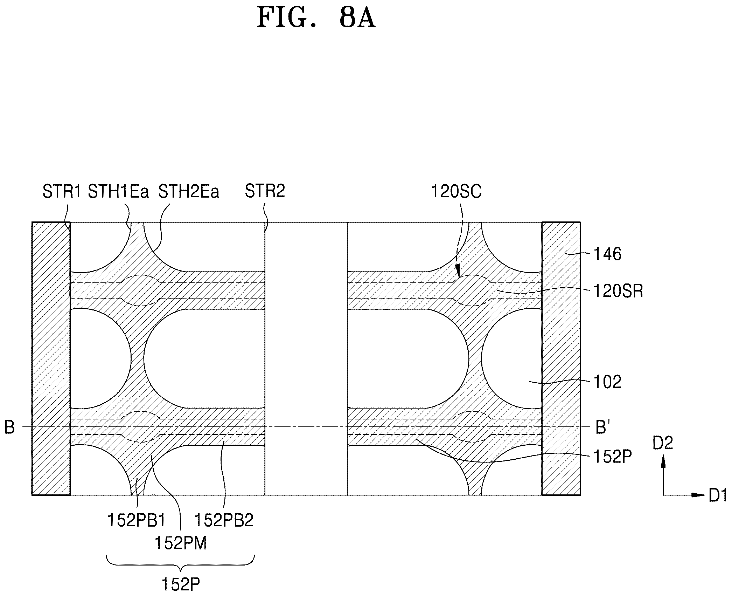

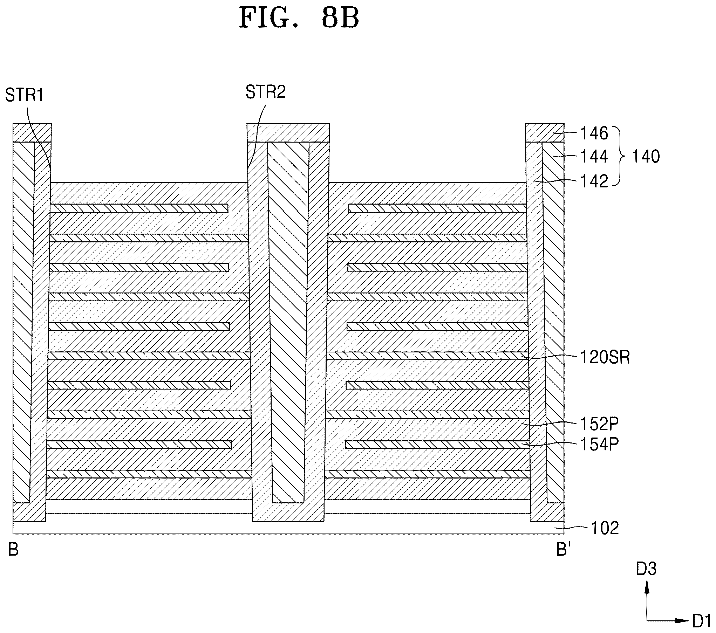

Referring to FIGS. 8A and 8B, a support insulating layer (not shown) covering surfaces of the plurality of single crystal slits 120S and an isolation insulating layer (not shown) covering a surface of the support insulating layer are formed.

Next, part of the isolation insulating layer is removed to form a plurality of isolation insulating patterns 154P arranged in the support insulating layer. In addition, part of the support insulating layer is removed to form a plurality of support patterns 152P arranged between the plurality of isolation insulating patterns 154P and the plurality of single crystal slits 120S.

Next, parts of the plurality of single crystal slits 120S are removed to form a plurality of single crystal bars 120SR arranged between two isolation insulating patterns 154P in the vertical direction D3. The plurality of single crystal bars 120SR may have a bar shape extending in the first horizontal direction D1 and having substantially the same thickness in the vertical direction D3.

The plurality of first stacked through holes STH1E and the plurality of second stacked through holes STH2E limited by the plurality of single crystal slits 120S may become a plurality of first stacked through holes STH1Ea and a plurality of second stacked through holes STH2Ea limited by the plurality of support patterns 152P and having a slightly deformed shape.

Between two adjacent first stacked through holes STH1Ea and two adjacent second stacked through holes STH2Ea, each of the plurality of support patterns 152P may have a main support 152PM having a large width in the first horizontal direction D1 and the second horizontal direction D2.

In a plan view, the plurality of support patterns 152P may have a plurality of main supports 152PM and a plurality of first support extensions 152PB1 and a plurality of second support extensions 152PB2 connecting the plurality of main supports 152PM to one another.

The single crystal bar 120SR may have an extension 120SC having a large width in the second horizontal direction D2 between two adjacent main supports 152PM. A remaining portion of the single crystal bar 120SR excluding the extension 120SC may have substantially the same width in the second horizontal direction D2.

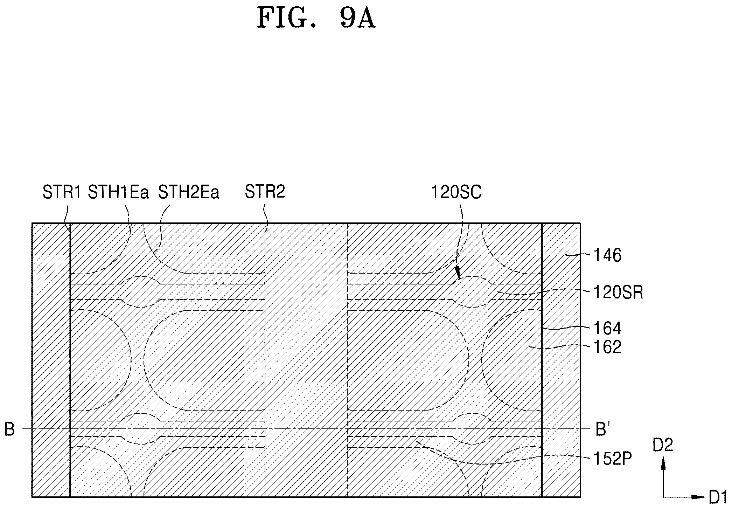

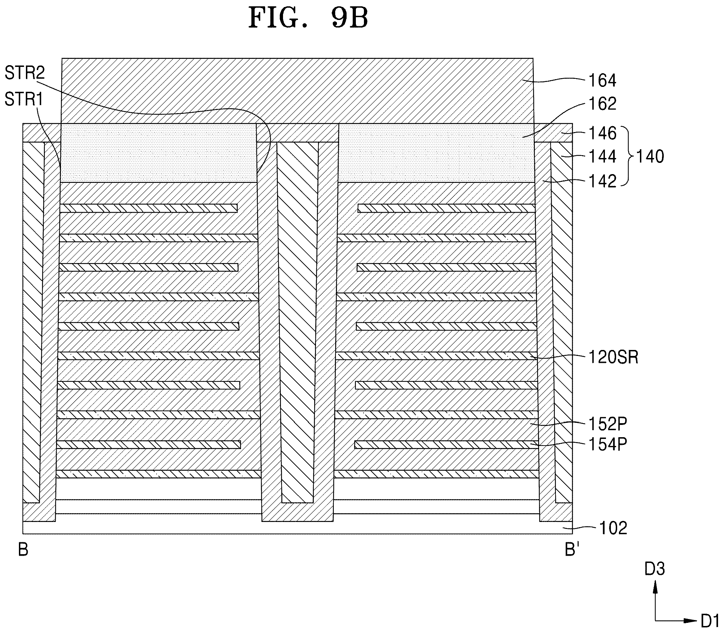

Referring to FIGS. 9A and 9B, a second buried insulating layer 162 is formed to cover the stacked structure of the plurality of single crystal bars 120SR, the plurality of support patterns 152P, and the plurality of isolation insulating patterns 154P, and to fill the plurality of first stacked through holes STH1Ea and the plurality of second stacked through holes STH2Ea.

Next, a third mask layer 164 covering the second buried insulating layer 162 and exposing at least part of a top surface of the buried structure 140 is formed. In some embodiments, the second buried insulating layer 162 may include any one of silicon oxide, silicon oxynitride, carbon-containing silicon oxide, carbon-containing silicon nitride, and/or carbon-containing silicon oxynitride and the third mask layer 164 may include silicon nitride.

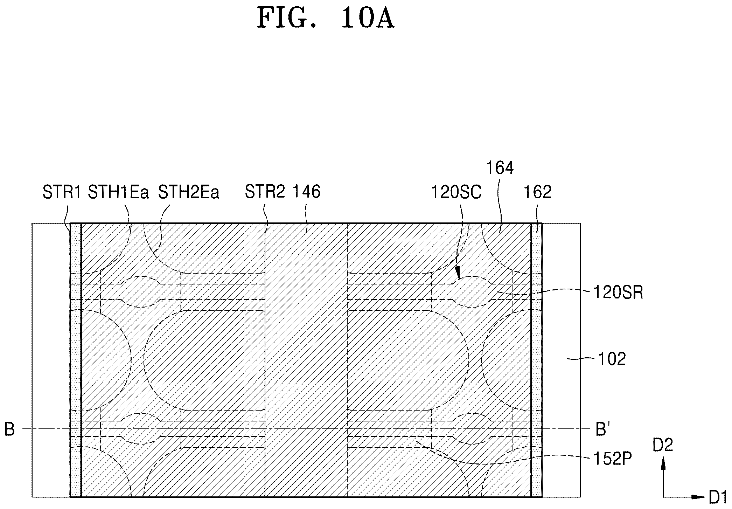

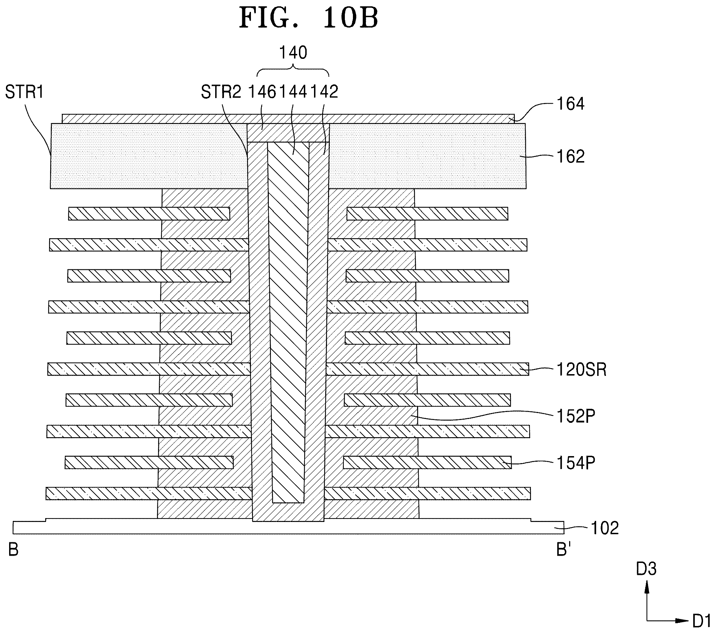

Referring to FIGS. 10A and 10B, after the buried structure 140 filling the first recess STR1 is removed, parts of the plurality of support patterns 152P are removed through the first recess STR1.

In the process of removing parts of the plurality of support patterns 152P, the plurality of single crystal bars 120SR and the plurality of isolation insulating patterns 154P may not be removed and may be interposed in the plurality of remaining support patterns 152P. Accordingly, the plurality of single crystal bars 120SR and the plurality of isolation insulating patterns 154P may be exposed to a space in which parts of the plurality of support patterns 152P are removed.

That is, parts of the plurality of single crystal bars 120SR and parts of the plurality of isolation insulating patterns 154P may be buried in the plurality of remaining support patterns 152P, and remaining parts of the plurality of single crystal bars 120SR and remaining parts of the plurality of isolation insulating patterns 154P may protrude (i.e. extend) from the plurality of remaining support patterns 152P toward the first recess STR1 in the first horizontal direction D1.

In the process of removing parts of the plurality of support patterns 152P, parts of the plurality of isolation insulating patterns 154P may also be removed. Because parts of the plurality of isolation insulating patterns 154P are removed, a horizontal length of each of the plurality of isolation insulating patterns 154P protruding (i.e. extending) from the plurality of support patterns 152P in the first horizontal direction D1 may be less than a horizontal length of each of the plurality of single crystal bars 120SR.

In the process of removing the buried structure 140 and parts of the plurality of support patterns 152P, part of the third mask layer 164 may also be removed to reduce a height and width of the third mask layer 164.

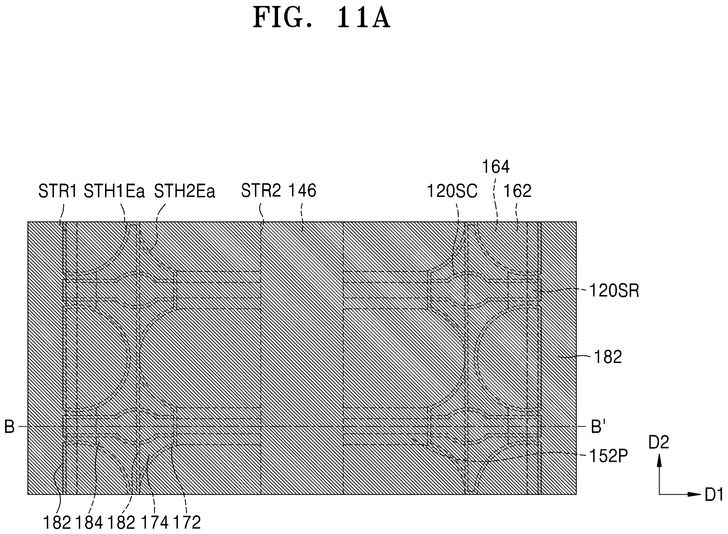

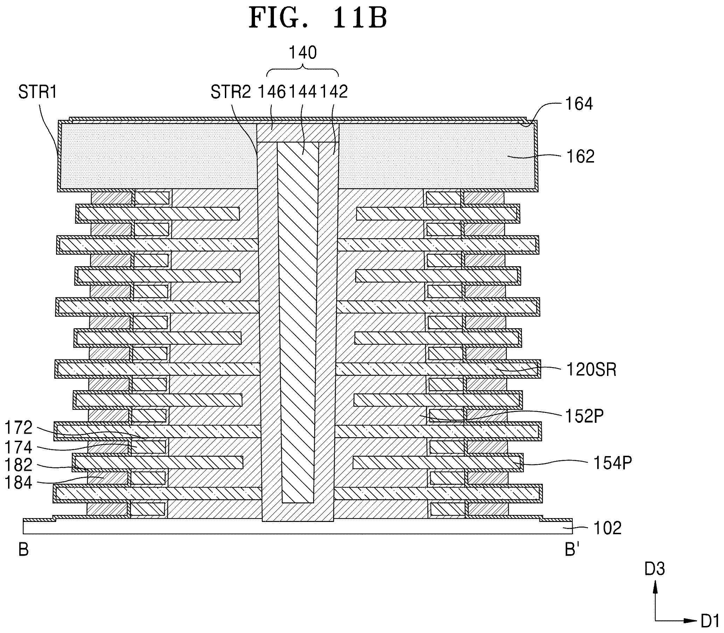

Referring to FIGS. 11A and 11B together, a spacer liner layer 172 covering part of a space between each of the plurality of single crystal bars 120SR and each of the plurality of isolation insulating patterns 154P adjacent to each other in the vertical direction D3, and a spacer buried layer 174 filling part of the space between each of the plurality of single crystal bars 120SR and each of the plurality of isolation insulating patterns 154P are formed.

In some embodiments, the spacer liner layer 172 may include silicon nitride, and the spacer buried layer 174 may include any one of silicon oxide, silicon oxynitride, carbon-containing silicon oxide, carbon-containing silicon nitride, and/or carbon-containing silicon oxynitride.

After the spacer liner layer 172 and the spacer buried layer 174 are formed, a gate dielectric layer 182 is formed to conformally cover exposed surfaces of the spacer liner layer 172 and the spacer buried layer 174 and a gate electrode 184 is formed to fill part of the remaining space between each of the plurality of single crystal bars 120SR and each of the plurality of isolation insulating patterns 154P.

The gate dielectric layer 182 may include at least one selected from silicon oxide, a high-k dielectric material having a higher dielectric constant than silicon oxide, and/or a ferroelectric material.

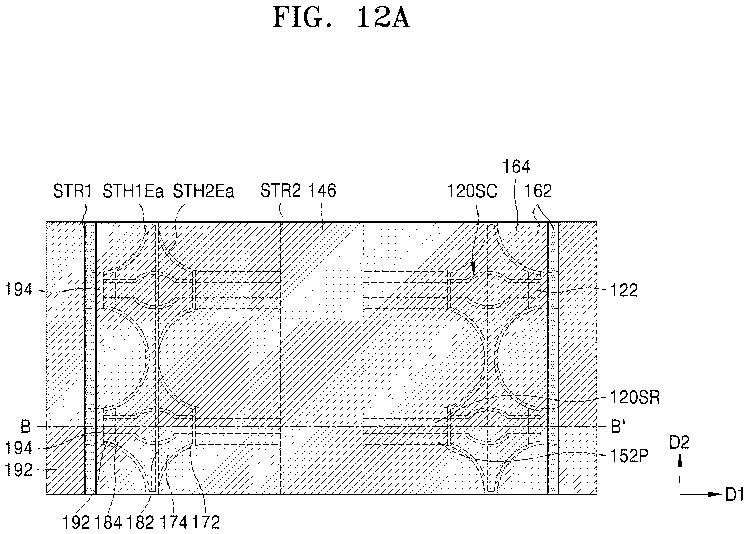

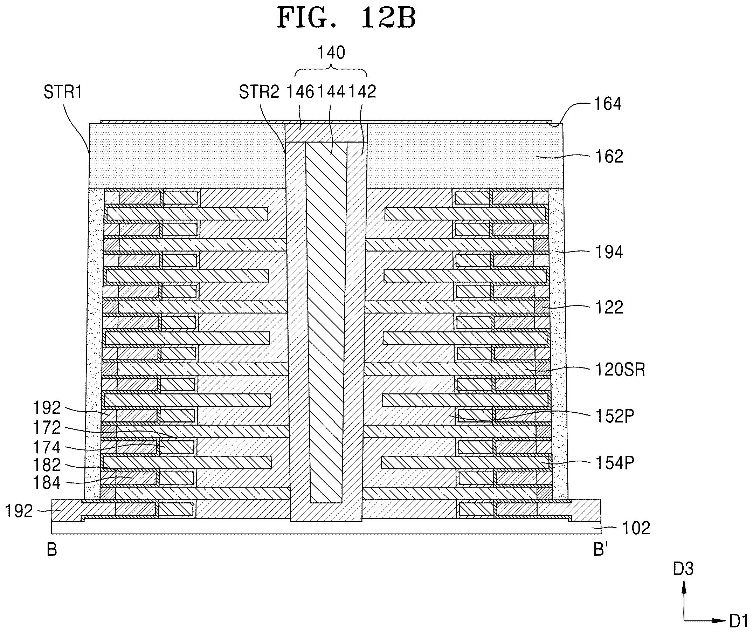

Referring to FIGS. 12A and 12B, a plurality of spacer capping layers 192 are formed to fill the remaining spaces between the plurality of single crystal bars 120SR and the plurality of isolation insulating patterns 154P in the vertical direction D3.

Next, parts of the plurality of single crystal bars 120SR protruding (i.e. extending) further than the plurality of isolation insulating patterns 154P from the plurality of support patterns 152P in the first horizontal direction D1 and a portion of the gate dielectric layer 182 covering the parts of the plurality of single crystal bars 120SR are removed. Ends of the plurality of single crystal bars 120SR facing the first recess STR1 may be exposed. A plurality of first source/drain regions 122 may be formed by injecting a dopant into the ends of the plurality of single crystal bars 120SR.

In some embodiments, some of the plurality of spacer capping layers 192 may cover a surface of the substrate 102 exposed to a bottom surface of the first recess STR1. For example, the plurality of spacer capping layers 192 may include silicon nitride.

Next, a plurality of bit lines 194 are formed in contact with the plurality of first source/drain regions 122. The plurality of bit lines 194 may extend in the vertical direction D3 along the second buried insulating layer 162 filling the plurality of first stacked through holes STH1Ea. In some embodiments, each of the plurality of bit lines 194 may be electrically connected to each first source/drain region 122 through the direct contact DC (refer to FIG. 2) located therebetween.

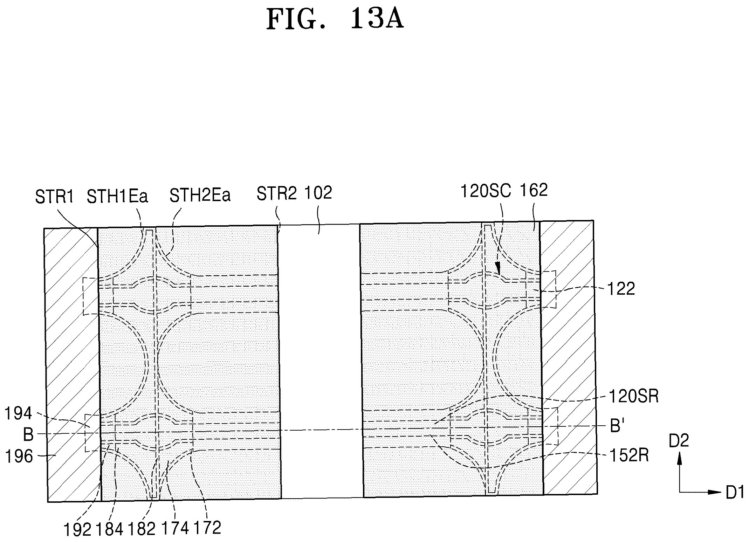

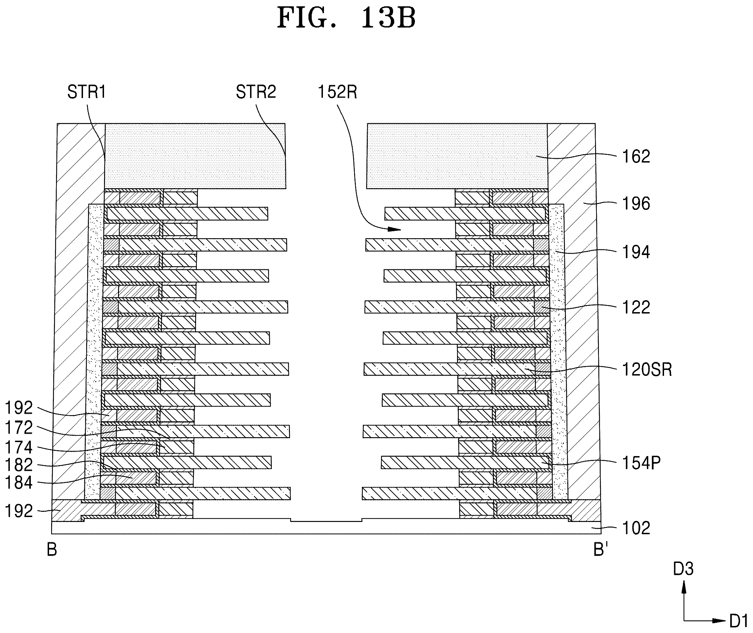

Referring to FIGS. 13A and 13B, a third buried insulating layer 196 is formed to fill the first recess STR1, the third mask layer 164 is removed, and the buried structure 140 filling the second recess STR2 is removed.

In some embodiments, the third buried insulating layer 196 may include silicon oxide. After the buried structure 140 filling the second recess STR2 is removed, the plurality of support patterns 152P are removed through the second recess STR2 to form a removal space 152R connected to the second recess STR2.

In the process of forming the removal space 152R, the plurality of single crystal bars 120SR and the plurality of isolation insulating patterns 154P may not be removed, and the plurality of single crystal bars 120SR and the plurality of isolation insulating patterns 154P may be exposed to the removal space 152R.

That is, parts of the plurality of single crystal bars 120SR and parts of the plurality of isolation insulating patterns 154P may be surrounded by the spacer liner layer 172 and the spacer buried layer 174, and the remaining parts of the plurality of single crystal bars 120SR and the remaining parts of the plurality of isolation insulating patterns 154P may protrude (i.e. extend) from the spacer liner layer 172 and the spacer buried layer 174 toward the second recess STR2 in the first horizontal direction D1.

Referring to FIG. 14, parts of the plurality of single crystal bars 120SR protruding (i.e. extending) from the spacer liner layer 172 and the spacer buried layer 174 toward the second recess STR2 in the first horizontal direction D1 are removed.

Next, a plurality of second source/drain regions 124 may be formed by injecting a dopant into the other ends (i.e., portions partially removed to be exposed) of the plurality of single crystal bars 120SR exposed through the second recess STR2. Portions remaining after the plurality of second source/drain regions 124 are formed among the plurality of single crystal bars 120SR may be formed as a plurality of channel regions 126.

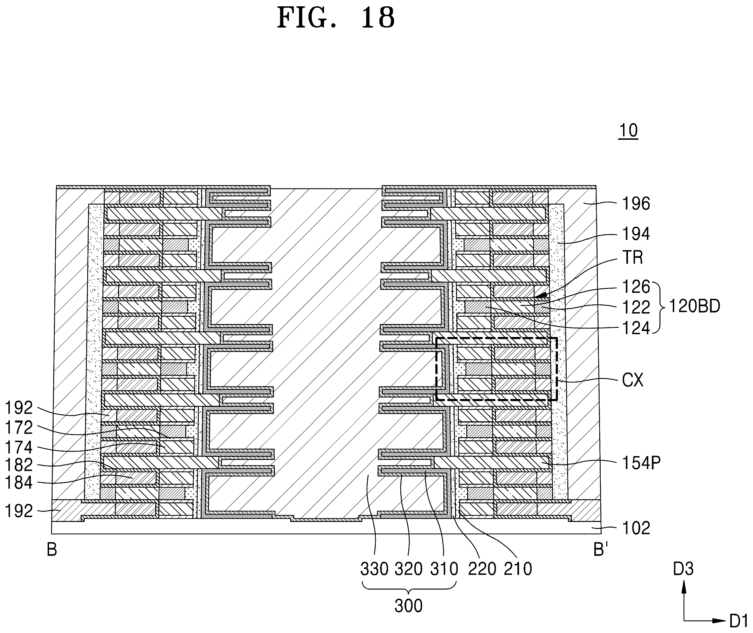

Accordingly, each of the plurality of single crystal bars 120SR may be referred to as a transistor body 120BD including the first source/drain region 122, the channel region 126, and the second source/drain region 124. For example, the transistor body 120BD may include a single crystal semiconductor material. That is, each of the first source/drain region 122, the channel region 126, and the second source/drain region 124 may include a single crystal semiconductor material. The transistor body 120BD, the gate dielectric layer 182, and the gate electrode 184 may form or make up the cell transistor TR (refer to FIG. 18).

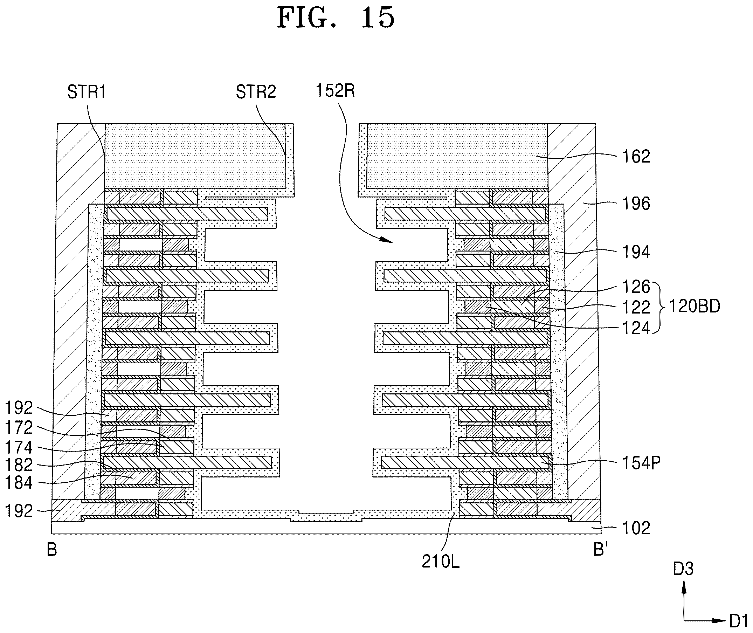

Referring to FIG. 15, a polysilicon forming layer 210L is conformally formed along an internal wall of the removal space 152R connected to the second recess STR2.

The polysilicon forming layer 210L may conformally cover an exposed top surface of the substrate 102, the plurality of second source/drain regions 124 of the plurality of transistor bodies 120BD, the plurality of isolation insulating patterns 154P, the spacer liner layer 172, and the spacer buried layer 174.

The polysilicon forming layer 210L may include polysilicon doped with an n-type dopant. For example, the dopant of the polysilicon forming layer 210L may be arsenic (As) or phosphorus (P). In some embodiments, the dopant of the polysilicon forming layer 210L may be substantially the same as a dopant used in the second source/drain region 124.

An n-type doping concentration of the polysilicon forming layer 210L may be between 1E20 and SE21 atoms/cm³ approximately. In some embodiments, the doping concentration of the polysilicon forming layer 210L may be higher than a doping concentration of the second source/drain region 124.

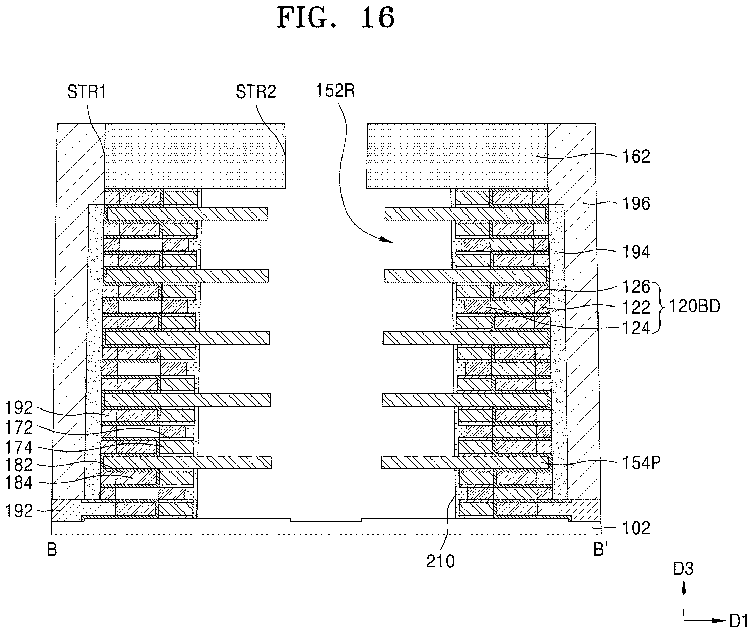

Referring to FIG. 16, an etching process is performed on the polysilicon forming layer 210L to form a plurality of doped polysilicon layers 210.

The plurality of doped polysilicon layers 210 may be formed by removing part of the polysilicon forming layer 210L through an isotropic etching process. The isotropic etching process may be a wet etching process. The isotropic etching process may be performed to have etch selectivity with respect to the substrate 102, the second source/drain region 124, the isolation insulating pattern 154P, the spacer liner layer 172, and the spacer buried layer 174.

As a result of the isotropic etching, the plurality of doped polysilicon layers 210 may be in contact with the plurality of second source/drain regions 124 of the plurality of transistor bodies 120BD and the spacer liner layer 172, and may be apart from one another in the vertical direction D3 by the plurality of isolation insulating patterns 154P. Each of the plurality of doped polysilicon layers 210 may have a concavo-convex (i.e. convex) structure protruding or extending in a direction in which the second source/drain region 124 is located. In some embodiments, due to characteristics of the isotropic etching process, etched surfaces (i.e., surfaces exposed to the outside) of the plurality of doped polysilicon layers 210 may be round (i.e., curved) surfaces.

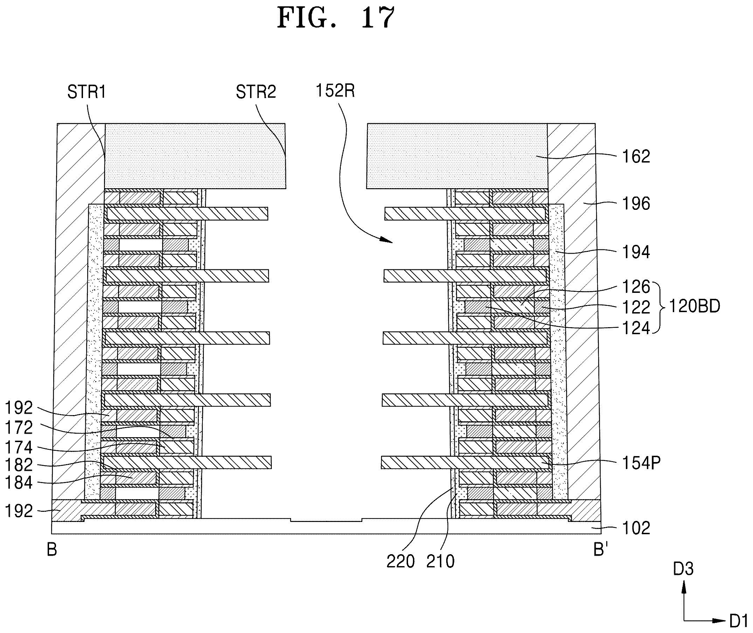

Referring to FIG. 17, a plurality of contact metal layers 220 are formed to cover or be on the etched surfaces of the plurality of doped polysilicon layers 210.

The plurality of contact metal layers 220 may be formed to contact the plurality of doped polysilicon layers 210 between the substrate 102 and the isolation insulating pattern 154P, among the plurality of isolation insulating patterns 154P, and between the second buried insulating layer 162 and the isolation insulating pattern 154P. That is, the plurality of contact metal layers 220 may be electrically connected to the plurality of second source/drain regions 124 through the plurality of doped polysilicon layers 210 without being in direct contact with the plurality of second source/drain regions 124 of the plurality of transistor bodies 120BD.

In some embodiments, when the etched surfaces of the plurality of doped polysilicon layers 210 are round (i.e. curved) surfaces, contact surfaces (i.e., surfaces in contact with the plurality of doped polysilicon layers) of the plurality of contact metal layers 220 may also be round (i.e., curved) surfaces.

The plurality of contact metal layers 220 may include at least one selected from a metal such as titanium (Ti), molybdenum (Mo), tungsten (W), cobalt (Co), tantalum (Ta), ruthenium (Ru), copper (Cu), zirconium (Zr), or nickel (Ni), metal nitride including the metal, and/or metal silicide including the metal. For example, the plurality of contact metal layers 220 may include titanium silicide.

Referring to FIG. 18, a storage electrode material layer is formed to conformally cover a surface exposed in the second recess STR2.

The storage electrode material layer may conformally cover surfaces of the plurality of contact metal layers 220 and the plurality of isolation insulating patterns 154P.

Next, by removing part of the storage electrode material layer covering the other ends of the plurality of isolation insulating patterns 154P facing the second recess STR2, a plurality of hollow cylinder-shaped storage electrodes 310 of which portions facing the second recess STR2 in the first horizontal direction D1 are opened and of which portions facing the plurality of second source/drain regions 124 are closed may be formed.

In some embodiments, after the other ends of the plurality of isolation insulating patterns 154P are exposed, parts of the plurality of isolation insulating patterns 154P may be removed. In other embodiments, parts of the plurality of isolation insulating patterns 154P may not be removed.

A capacitor dielectric layer 320 may be formed to conformally cover the plurality of hollow cylinder-shaped storage electrodes 310 and a plate electrode 330 may be formed to cover the capacitor dielectric layer 320 and to fill the second recess STR2 to form a cell capacitor 300.

The capacitor dielectric layer 320 may cover at least part of an internal surface and an external surface of each of the plurality of hollow cylinder-shaped storage electrodes 310. The plate electrode 330 may partially or completely fill each of the plurality of hollow cylinder-shaped storage electrodes 310.

Through such manufacturing processes, the semiconductor device 10 according to some embodiments may be manufactured.

Referring back to FIG. 18, components included in the semiconductor device 10 according to the inventive concept will be described in detail as follows.

The semiconductor device 10 according to the inventive concept may include the plurality of bit lines 194 apart from one another in the first horizontal direction D1 and the second horizontal direction D2 on the substrate 102 and extending parallel to one another in the vertical direction D3.

The plurality of transistor bodies 120BD that make up or form the cell transistor TR may be apart from one another in the second horizontal direction D2 and the vertical direction D3, and may extend parallel to one another in the first horizontal direction D1. Each of the plurality of transistor bodies 120BD includes the first source/drain region 122, the channel region 126, and the second source/drain region 124 sequentially arranged in the first horizontal direction D1, and the first source/drain region 122 may be connected to any one of the plurality of bit lines 194. In some embodiments, the direct contact DC (refer to FIG. 2) may be formed between the first source/drain region 122 and the bit line 194.

The plurality of cell capacitors 300 may be electrically connected to the plurality of second source/drain regions 124 of the plurality of transistor bodies 120BD through the plurality of doped polysilicon layers 210 and the plurality of contact metal layers 220. The bit line 194 and the cell capacitor 300 may be arranged on opposite sides of the transistor body 120BD connected to each other in the first horizontal direction D1.

The transistor body 120BD and the cell capacitor 300 may be sequentially arranged from the bit line BL in the first horizontal direction D1. The cell transistor TR including the transistor body 120BD, the gate dielectric layer 182, and the gate electrode 184 and the cell capacitor 300 including the storage electrode 310, the capacitor dielectric layer 320, and the plate electrode 330 may form or constitute one memory cell MC (refer to FIG. 1).

In the semiconductor device 10 according to the inventive concept, the doped polysilicon layer 210 and the contact metal layer 220 may be arranged between the second source/drain region 124 and the storage electrode 310. Accordingly, doping concentrations of the doped polysilicon layer 210, the second source/drain region 124, and the channel region 126 may gradually change in the first horizontal direction D1. That is, contact resistance between the contact metal layer 220 including a metal and the second source/drain region 124 including single crystal silicon (Si) may be reduced through doping concentration gradient.

In general, when only the contact metal layer 220 is formed between the transistor body 120BD and the cell capacitor 300 in the vertical semiconductor device 10 having a three-dimensional structure, because the contact metal layer 220 is bonded to the second source/drain region 124 that is recessed compared to surrounding components, a contact surface may be flat. In addition, a gas phase doping process is used to inject a dopant in the horizontal direction into the transistor body 120BD stacked in the vertical direction D3.

In the semiconductor device 10 according to the inventive concept, the doped polysilicon layer 210 and the contact metal layer 220 may be arranged between the second source/drain region 124 and the storage electrode 310. That is, by arranging the doped polysilicon layer 210 having a high doping concentration and a large contact surface area between the second source/drain region 124 and the contact metal layer 220, contact resistance between single crystal silicon (Si), a different type of material, and a metal may be efficiently reduced.

In the semiconductor device 10 according to the inventive concept, in order to reduce contact resistance between the contact metal layer 220 and the transistor body 120BD, the doped polysilicon layer 210 having a high doping concentration and a large contact area is formed between the contact metal layer 220 and the transistor body 120BD. Accordingly, stable electrical performance and improved reliability may be provided.

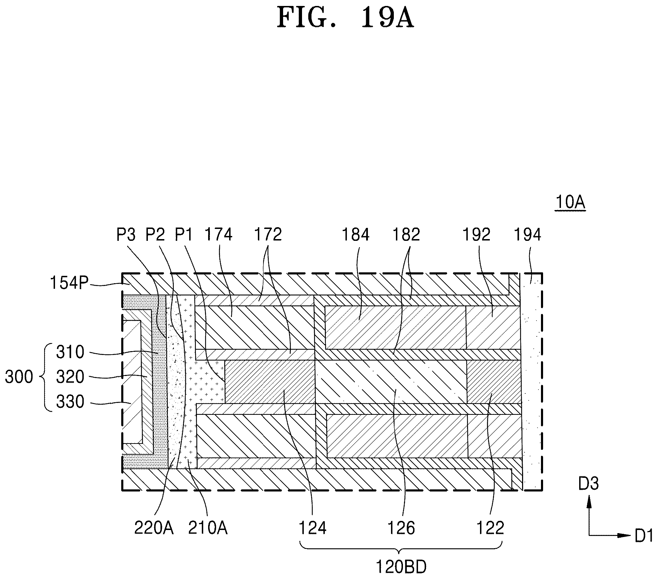

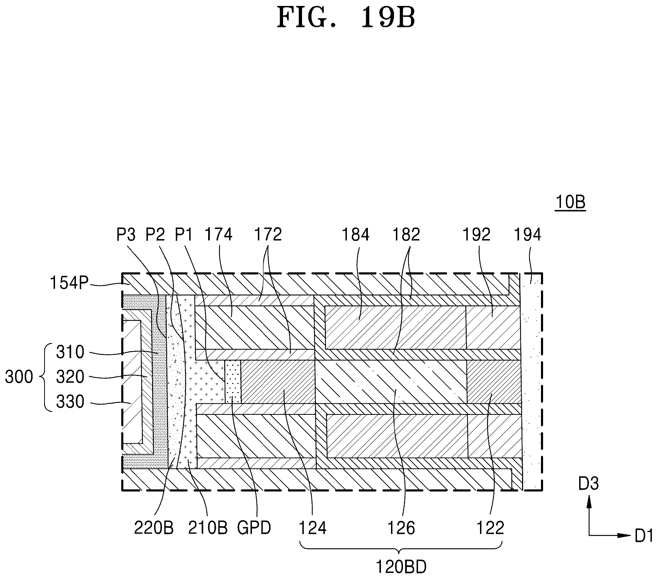

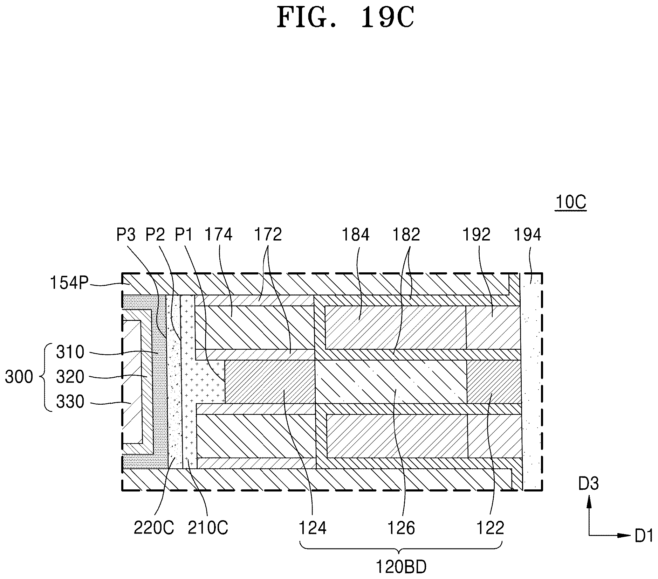

FIGS. 19A, 19B, and 19C are enlarged cross-sectional views illustrating parts of semiconductor devices 10A, 10B, and 10C according to some embodiments.

Specifically, the cross-sectional views illustrate enlarged portion CX of FIG. 18. In addition, doped polysilicon layers 210A, 210B, and 210C described below correspond to a modification of the doped polysilicon layer 210, and contact metal layers 220A, 220B, and 220C correspond to a modification of the contact metal layer 220.

Referring to FIG. 19A, in the semiconductor device 10A according to the inventive concept, the doped polysilicon layer 210A and the contact metal layer 220A are arranged between a second source/drain region 124 and a storage electrode 310.

The semiconductor device 10A of some embodiments may have a first contact surface P1 in which the doped polysilicon layer 210A contacts the second source/drain region 124, a second contact surface P2 in which the doped polysilicon layer 210A contacts the contact metal layer 220A, and a third contact surface P3 in which the contact metal layer 220A contacts the storage electrode 310.

In the semiconductor device 10A of some embodiments, an area of the first contact surface P1 may be less than each of an area of the second contact surface P2 and an area of the third contact surface P3 due to the second source/drain region 124 recessed compared to the surrounding components. That is, the doped polysilicon layer 210A may have a concavo-convex (i.e. convex) structure protruding or extending in a direction in which the second source/drain region 124 is located.

In the semiconductor device 10A of some embodiments, as described above, when an isotropic etching (e.g., wet etching) process is used to form the doped polysilicon layer 210A, the second contact surface P2 may be a round (i.e. curved) surface, and the first contact surface P1 and the third contact surface P3 may be flat surfaces.

Referring to FIG. 19B, in the semiconductor device 10B according to the inventive concept, a gas phase doping layer GPD, a doped polysilicon layer 210B, and a contact metal layer 220B are arranged between a second source/drain region 124 and a storage electrode 310.

In the semiconductor device 10B of some embodiments, the gas phase doping layer GPD may refer to a region in which part of the second source/drain region 124 is doped by using a gas phase doping process. That is, the gas phase doping layer GPD may be a portion of the second source/drain region 124 having a different doping concentration.

The semiconductor device 10B of some embodiments may have a first contact surface P1 in which the doped polysilicon layer 210B contacts the gas phase doping layer GPD, a second contact surface P2 in which the doped polysilicon layer 210B contacts the contact metal layer 220B, and a third contact surface P3 in which the contact metal layer 220B contacts the storage electrode 310.

In the semiconductor device 10B of some embodiments, an area of the first contact surface P1 may be less than each of an area of the second contact surface P2 and an area of the third contact surface P3 due to the gas phase doping layer GPD and the second source/drain region 124 that is recessed compared to surrounding components. That is, the doped polysilicon layer 210B may have a concavo-convex (i.e. convex) structure protruding or extending in a direction in which the gas phase doping layer GPD is located.

In the semiconductor device 10B of some embodiments, as described above, when an isotropic etching (e.g., wet etching) process is used to form the doped polysilicon layer 210B, the second contact surface P2 may be a round (i.e. curved) surface, and the first contact surface P1 and the third contact surface P3 may be flat surfaces.

Referring to FIG. 19C, in the semiconductor device 10C according to the inventive concept, the doped polysilicon layer 210C and the contact metal layer 220C are arranged between a second source/drain region 124 and a storage electrode 310.

The semiconductor device 10C of some embodiments may have a first contact surface P1 in which the doped polysilicon layer 210C contacts the second source/drain region 124, a second contact surface P2 in which the doped polysilicon layer 210C contacts the contact metal layer 220C, and a third contact surface P3 in which the contact metal layer 220C contacts the storage electrode 310.

In the semiconductor device 10C of some embodiments, an area of the first contact surface P1 may be less than each of an area of the second contact surface P2 and an area of the third contact surface P3 due to the second source/drain region 124 that is recessed compared to the surrounding components. That is, the doped polysilicon layer 210C may have a concavo-convex structure (i.e. convex) protruding or extending in a direction in which the second source/drain region 124 is located.

In the semiconductor device 10C of some embodiments, as described above, when an isotropic etching (e.g., wet etching) process is used to form the doped polysilicon layer 210C, the first contact surface P1, the second contact surface P2, and the third contact surface P3 may be flat surfaces.

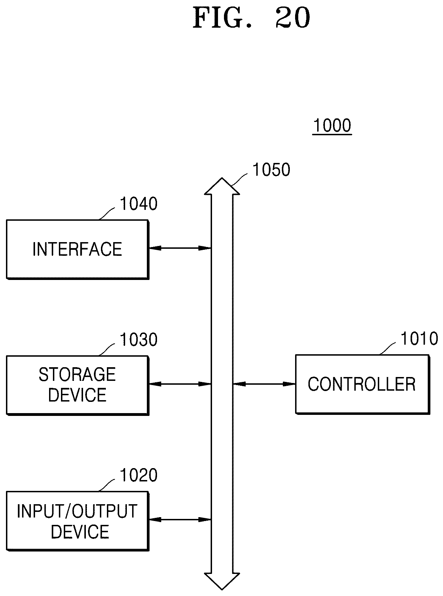

FIG. 20 is a block diagram illustrating a system 1000 including a semiconductor device according to some embodiments.

Referring to FIG. 20, the system 1000 includes a controller 1010, an input/output device 1020, a storage device 1030, an interface 1040, and a bus 1050.

The system 1000 may be a mobile system or a system transmitting or receiving information. In some embodiments, the mobile system may include a portable computer, a web tablet, a mobile phone, a digital music player, or a memory card.

The controller 1010 for controlling an execution program in the system 1000 may include a microprocessor, a digital signal processor, a microcontroller, or a similar device.

The input/output device 1020 may be used to input or output data of the system 1000. The system 1000 may be connected to an external device, for example, a personal computer or a network by using the input/output device 1020 and may exchange data with the external device. The input/output device 1020 may be, for example, a touch screen, a touch pad, a keyboard, or a display.

The storage device 1030 may store data for an operation of the controller 1010 or data processed by the controller 1010. The storage device 1030 may include any one of the semiconductor devices 10, 10A, 10B, and/or 10C according to the inventive concept described above.

The interface 1040 may be a data transmission path between the system 1000 and the external device. The controller 1010, the input/output device 1020, the storage device 1030, and the interface 1040 may communicate with one another through the bus 1050.

While the inventive concept has been particularly shown and described with reference to embodiments thereof, it will be understood that various changes in form and details may be made therein without departing from the scope of the following claims.

## Claims

1. A semiconductor device (10) comprising:
a bit line (194) extending in a vertical direction (D3) on a substrate (102);
a transistor body (120BD) electrically connected to the bit line (194) and including a first source/drain region (122), a channel region (126), and a second source/drain region (124) in a first horizontal direction (D1);
a gate electrode (184) extending in a second horizontal direction (D2) intersecting the first horizontal direction (D1) and on the channel region (126), wherein a gate dielectric layer (182) is between the gate electrode (184) and the channel region (126); and
a cell capacitor (300) electrically connected to the second source/drain region (124) and including a storage electrode (310), a capacitor dielectric layer (320) and a plate electrode (330) in the first horizontal direction (D1),
wherein a doped polysilicon layer (210) and a contact metal layer (220) are both between the second source/drain region (124) and the storage electrode (310).

2. The semiconductor device (10) of claim 1, wherein the doped polysilicon layer (210), the second source/drain region (124), and the channel region (126) are in contact with one another, and have respective doping concentrations that vary along the first horizontal direction (D1).

3. The semiconductor device (10) of claim 2, wherein the doping concentration of the doped polysilicon layer (210) is greater than the doping concentration of the second source/drain region (124).

4. The semiconductor device (10) of any one of claims 1 to 3, wherein a dopant of the doped polysilicon layer (210) is same as a dopant of the second source/drain region (124).

5. The semiconductor device (10) of any one of claims 1 to 4, wherein the doped polysilicon layer (210) is doped with an n-type dopant, and
wherein an n-type doping concentration of the doped polysilicon layer (210) is between 1E20 and 5E21 atoms/cm³.

6. The semiconductor device (10) of any one of claims 1 to 5, wherein an area of a first contact surface (P1) where the doped polysilicon layer (210) and the second source/drain region (124) are in contact with each other is less than an area of a second contact surface (P2) where the doped polysilicon layer (210) and the contact metal layer (220) are in contact with each other and less than an area of a third contact surface (P3) where the contact metal layer (220) and the storage electrode (310) are in contact with each other.

7. The semiconductor device (10) of claim 6, wherein the first contact surface (P1) and the third contact surface (P3) comprise flat surfaces, and the second contact surface (P2) comprises a curved surface.

8. The semiconductor device (10) of any one of claims 1 to 7, wherein the doped polysilicon layer (210) has a convex surface that extends toward the second source/drain region (124).

9. The semiconductor device (10) of any one of claims 1 to 8, wherein the first source/drain region (122), the channel region (126), and the second source/drain region (124) comprise respective single crystal semiconductor materials.

10. The semiconductor device (10) of any one of claims 1 to 9, wherein the contact metal layer (220) comprises at least one metal comprising titanium, Ti, molybdenum, Mo, tungsten, W, cobalt, Co, tantalum, Ta, ruthenium, Ru, copper, Cu, zirconium, Zr, or nickel, Ni, a metal nitride and/or a metal silicide,
wherein the metal nitride and the metal silicide comprise the at least one metal.

11. The semiconductor device (10) according to any one of the previous claims, further comprising:
the one or more transistor bodies (120BD) spaced apart from one another in a vertical direction (D3) on a substrate (102) and extending in parallel in a first horizontal direction (D1), wherein ones of the one or more transistor bodies (120BD) comprise a first source/drain region (122), a channel region (126), and a second source/drain region (124);
the one or more gate electrodes (184) spaced apart from one another in the vertical direction (D3), extending in parallel to one another in a second horizontal direction (D2) intersecting the first horizontal direction (D1), wherein ones of the one or more gate electrodes (184) are on at least a top surface and a bottom surface of the channel region (126) of a respective one of the one or more transistor bodies (120BD), and wherein a gate dielectric layer (182) is between the channel region (126) and the ones of the one or more gate electrodes (184);
the one or more bit lines (194) spaced apart from one another in the second horizontal direction (D2) on the substrate (102), and extending in parallel in the vertical direction (D3), wherein respective ones of the one or more bit lines (194) are electrically connected to the first source/drain region (122) of respective ones of the one or more transistor bodies (120BD); and
a cell capacitor (300) including the one or more storage electrodes (310), a capacitor dielectric layer (320), and a plate electrode (330), and electrically connected to the second source/drain region (124) of respective ones of the one or more transistor bodies (120BD),
wherein respective ones of the one or more doped polysilicon layers (210) are between the second source/drain region (124) of respective ones of the one or more transistor bodies (120BD) and respective ones of the one or more storage electrodes (310).

12. The semiconductor device (10) of claim 11, wherein a doping concentration of respective ones of the one or more doped polysilicon layers (210) is higher than a doping concentration of the second source/drain region (124) of respective ones of the one or more transistor bodies (120BD), and
wherein a dopant of respective ones of the one or more doped polysilicon layers (210) is same as a dopant of the second source/drain region (124) of respective ones of the one or more transistor bodies (120BD).

13. The semiconductor device (10) of claim 12, wherein the dopant of respective ones of the one or more doped polysilicon layers (210) comprises arsenic (As) or phosphorus (P), and
wherein the doping concentration of respective ones of the one or more doped polysilicon layers (210) is between 1E20 and 5E21 atoms/cm³.

14. The semiconductor device (10) of any one of claims 11 to 13, wherein respective ones of the one or more contact metal layers (220) are between respective ones of the one or more storage electrodes (310) of the cell capacitor (300) and respective ones of the one or more doped polysilicon layers (210).

15. The semiconductor device (10) of claim 14, wherein an area of a first contact surface (P1) where respective ones of the one or more doped polysilicon layers (210) is in contact with the second source/drain region (124) of respective ones of the one or more transistor bodies (120BD) is less than an area of a second contact surface (P2) where respective ones of the one or more doped polysilicon layers (210) is in contact with respective ones of the one or more contact metal layers (220), and
wherein the second contact surface (P2) comprises a convex surface that extends towards the second source/drain region (124) of respective ones of the one or more transistor bodies (120BD).
